# EUROPEAN PATENT APPLICATION

(11) **EP 2 803 753 A1**
(43) Date of publication of application: **19.11.2014**
(21) Application number: 13167555.5
(22) Date of filing: 13.05.2013
(51) Int. Cl.: C23C 14/20, C23C 14/02, A43B 1/00, A43B 1/14, C08J 7/04

(54) **Soft and flexible metallized polymeric article, method for producing the same, footwear with soft and flexible metallized polymeric component, method for producing footwear.**

(71) Applicant: Grendene S/A, 62040-050 Sobral, CE (BR)
(72) Inventor: Radelli Pasqual, Eduardo, CEP 95180-000 Rio Grande do Sul (RS) (BR)
(74) Representative: Capasso, Olga

(57) **Abstract**

The present invention provides soft, flexible and metallized polymeric articles, particularly useful in the production of footwear and/or components. The process for obtaining the polymeric article of the invention uses vacuum techniques, providing advantageous features for the large-scale industrial production of footwear and footwear accessories, which can be bent, twisted and deformed without losing the metalized look, i.e. maintaining the reflectivity of the metal layer.

## Description

### Field of the Invention

The present invention relates to the field of footwear engineering. More specifically, the present invention relates to a process for producing metalized soft and flexible article using vacuum techniques and the polymeric article resulting from this process, which provides adequate characteristics for the manufacture of shoes and accessories for shoes, which can be bent, twisted and deformed without losing the metalized look, i.e. maintaining the reflectivity of the metalized layer.

### Background of the Invention

The development of technical solutions in footwear engineering is the subject of intense interest, both to circumvent the limitations of known industrial processes and to provide improvements to users.

The metal products or products with metallic details have always been objects of great desire to the consumer, thus industries that work basically with polymers are at the margin of this audience, in view of the large investment for the adequacy of the production line to such products.

The metallization of plastics consists in the coating of the plastic surface with a metal film. This coating can be done through processes such as vacuum metallization and the electroplating. The lamination process is also considered as a way of aggregating a metallic film to plastic films.

### Vacuum Metallization

The vacuum metallization of plastics offers advantages in coating of parts with very thin layers of metals or metal oxides. In addition, the vacuum metallization can be applied to parts with various formats and is a profitable process for large-scale production. Such process starts with a preliminary treatment of the part in a vacuum chamber, in which a voltage is applied to the part, with the intention of cleaning it and producing an improvement in adhesion.

The vaporization of the element to be used in metallization is done under vacuum. The material is heated and the steam atoms condense on the parts to be coated. The plastic pieces are kept under relatively low temperature during steaming, having no possibility of deformation thereof.

The most commonly used metal in metal plating is aluminum, with its purity ranging from 99.6 to 99.99%, with which long lasting, high reflectance, silver gloss metal layers can be obtained, which, in combination with yellow lacquer, can provide golden gloss. Other metals appropriate to their vaporization are gold, copper and chromium. Among the oxides, there is the silicon monoxide.

Several types of plastics can be metallized by this process, such as polystyrene, poly(methyl methacrylate), acrylonitrile-butadiene-styrene terpolymer, polycarbonate, polypropylene and polyethylene.

### Electroplating

In order to galvanize a piece of plastic it is necessary to create an electrical contact of the part with the galvanic bath, which it is done by applying a metal surface by means of immersion in solutions containing metallic salts. The electroplating in nonconductive materials began in the nineteenth century. The non-conducting material was brushed with very fine graphite, a copper film was precipitated by reduction and finally a galvanic metallic layer. This process had the inconvenience of instability of copper solutions used for the coating and to minimize the problem, electroplating processes were developed, where metal solutions and the reducing solution are added at the same time on the material. This metallization process by electroplating has been widely used for the ABS plastic (acrylonitrile-butadiene-styrene), but can also be used for other types of plastics, such as polypropylene and fluorinated polymers.

The process of electroplating is used in the automotive industry (in the metallization of cranks, doorknobs, ornaments and badges), in the manufacturing of home appliances (blender frames, buttons for radio and television, polisher frames), hardware (towel rack, door hardware), metallization of cards and other applications.

The metallization steps consist of the cleaning of the part, conditioning, neutralizing, activation, acceleration and metallization itself. The part is initially cleaned with alkaline solutions for the removal of demolding agents, dust and other types of dirt, and subsequently is washed with cold water neutralized with acidic solutions and again with cold water.

The surface of the part is conditioned by means of immersion in sulfochromic solution, which promotes microcauterization of the part, providing a greater wettability. The part is then immersed in a solution of tin chloride, which purpose is to create metal cores in the part, through reduction of metals. Then, the part is immersed in a palladium chloride or sulphate solution, where the palladium ions reduce to palladium metal, and these germs of palladium are distributed over the surface of the part. This step lasts for about a minute. Then, a non-electrolytic pre-plating of the part is promoted by immersion in baths containing of copper or nickel solutions. The copper or nickel coated part is conductive, therefore, one can use conventional plating methods to accelerate the formation of metallic films. There are processes of direct plating under development, i.e., without the need of the initial layer of metal on the part, offering, in this way, the advantage of a faster process and saving water and energy.

In the conventional plating process, after the initial metallization or in direct form, in general, a first layer of shiny copper is applied, followed by nickel, and subsequently chromium. Other combinations of coating are possible, depending on the purpose of the part and according to the requirements in relation to corrosion.

### Lamination

In the laminating processes, two or more plastic materials are coated or impregnated with resin and pressed together until cure, forming a single reinforced structure. The process can be batch or continuous, under high or low molding pressure. This process is widely used in the packaging industry and electrical circuits. In the industry, laminates are used because of their electrical properties, impact resistance, high chemical and weather resistance.

With respect to the metals used in the metallization processes presented herein (electroplating, vacuum metallization and lamination), it should be noted that aluminum, palladium, copper, nickel, tin, lead, silver and gold metals are the most commonly used. Such currently available metallization processes in polymers are generally applicable to hard polymers or do not fit the softness and flexibility needed to polymers employed in footwear industry.

In the field of patents, some documents describe methods of metallizing polymers. The references that circumscribe the invention, without however anticipating or even suggest it, are listed below.

Document PI 0405143-2 presents a metallizeable coating composition and a process for applying the metallizeable coating composition on materials of difficult metallization through galvanic processes. The present invention differs from said document, among other technical reasons, in that it does not involve galvanic processes and provides a soft and flexible polymer by means of vacuum techniques.

Document PI 0405529-2 describes a process for metallizing a means of support (such as door handles and the like) made of plastic material, which consists in metallization through bathing at a temperature lower than the melting point of a high temperature polymer. The present invention differs from said document, among other technical reasons, in that it does not involve bathing of the parts and provides a soft and flexible polymer by means of vacuum techniques.

Document PI 0400446-9 describes a process of transfering vacuum metallization from the use of plastic films for other flexible substrates, being directed to plastic packaging and other ornamentation.

Document US 4,101,698, assigned to Avery International Corp and entitled "Elastomeric reflective metal surfaces", discloses a transfer elastomeric laminate for decorative use. The elastomeric layer must be transparent and can be of various materials, such as polyurethane film, and a highly reflective metal layer, such as chromium, linked to the elastomeric layer. The metal is applied by vapor deposition in microscopically discontinuous quantities, but with continuous visual appearance. The laminated can be deformed to conform to three dimensional objects and can be linked to an elastomeric substrate such as urethane rubbers to produce an article having reflective metal surface which can be twisted without losing the reflectivity of the metal layer. In particular, the metallic layer is applied to an elastomeric film separately, planar discontinuous segments.

Document US 5,035,940 discloses a fluoropolymer and aluminum laminate having an environment resistant polymeric coating.

Document US 5,536,539 presents an injection molded plastic article having integral pigmented coating film resistant to certain weather conditions. Such article comprises a molded polymer substrate and a decorative coating film adhered to one side of the substrate. These articles are particularly suitable for use as car body dashboards and the like.

Document US 4,115,619 discloses a highly reflective multilayer organic polymer/metal composite. Such composite is formed by plating a layer of a thermoplastic polymer with a soft metal, such as indium. The metal layer is applied by conventional techniques, such as vacuum deposition, metallization, or lamination. The metallic film can be molded into the desired shape using conventional conformation processes.

Document US 4,403,004 demonstrates a sandwich metallic resin laminate formed by a thermoformable base layer which is coated on both sides with vapor deposited metal. This laminate is able to be thermomolded for assuming three dimensional shapes. However, such moldable laminated films have little flexibility, and often break when metallic substrates are excessively deformed. They tend to lose brightness over the time, which is particularly pernicious with respect to metallic indium layers, which, in the presence of halogen-containing polymers (for example, polyvinyl chloride) can undergo an oxidation-reduction reaction that converts elemental indium to indium trichloride and further suffer with corrosion problems.

Document US 6,565,955, entitled "Bright indium-metallized formable film laminate", to Soliant LCC, discloses a glossy metallic film comprising polyvinylidene difluoride coating and a layer of discontinuous islands of indium deposited on a formable leveling layer.

The present invention differs from the above-cited documents, among other technical reasons, for being of a distinct technical field, comprising the direct metallizing on substrate with the use of adhesives to attach the metal, and not from the obtaining of a metallic film and subsequent transfer of the metallic film on the desired substrate.

Thus, it is still of great industrial interest to search for alternatives of polymer metallization processes which are inexpensive, efficient and result in a metalized soft and flexible polymer (having elasticity) for manufacturing footwear and/or accessories for footwear, which can be bent, twisted and deformed without losing the metalized look, i.e. maintaining the reflectivity of the metallic layer.

From what is clear from the searched literature, no documents were found anticipating or suggesting the teachings of the present invention, so that the solution proposed herein, the eyes of inventors, has novelty and inventive step in view of the prior art.

### Summary of the Invention

The present invention provides: a process for producing soft, flexible and metalized polymeric article (having elasticity); the polymeric article thus obtained; footwear and/or components comprising soft, flexible and metalized polymer; and a process for the industrial production of footwear. The processes of the invention include the use of vacuum techniques for the deposition of metal and/or metal particles on an adhesive layer. The soft flexible and metalized polymeric article of the invention provides adequate characteristics for the manufacturing of footwear and footwear accessories, which can be bent, twisted and deformed without losing the metalized look, i.e. maintaining the reflectivity of the metal layer.

It is, therefore, one of the objects of the present invention a process for producing a soft, flexible and metalized polymeric article comprising the following steps:
a) applying an adhesive on a soft and flexible polymeric substrate;
b) applying metal or metal particles on said adhesive with a vacuum system; and
c) applying a protective varnish layer on the metallic film.

Optionally, the step of applying adhesive is preceded by a step of cleaning the substrate.

In a preferred embodiment, the process of the present invention uses techniques that provide systems in vacuum for evaporation and deposition of metal. Preferably, the techniques used are: Sputtering, thermal evaporation, ion beam, ion plating and chemical vapor deposition, preferably magnetron sputtering.

It is an additional object of the present invention a metalized soft and flexible polymeric article, comprising a substrate, an intermediate adhesive, metal particles adhered to the adhesive, followed by a protective varnish. The metalized article of the invention can be bent, twisted and deformed without losing the metalized look, i.e. maintaining the reflectivity of the metallic layer.

It is another object of this invention a footwear and/or component comprising a metalized soft and flexible polymer. The footwear and/or component of the invention can be bent, twisted and deformed without losing the metalized look, i.e. maintaining the reflectivity of the metallic layer.

It is an additional object of the invention a process for the industrial production of footwear comprising at least a step of using a metalized soft and flexible polymer, comprising a substrate, an intermediate adhesive and metallic particles adhered to the adhesive.

These and other objects of the invention shall be immediately appreciated by persons skilled in the art and by companies with interests in the segment, and will be described in sufficient detail for its reproduction in the following description.

### Brief Description of Figures

Figure 1 shows a cut representing the different layers that make up the product, where: (11) represents the protective varnish; (12) the region containing metal particles; (13) the adhesive; and (14) the substrate.
Figure 2 shows a schematic representation of a cut of footwear of the invention comprising soft, flexible and metalized polymer, being indicated: in 21, the inner surface, and in 22, the outer surface having a metalized look.

### Detailed Description of the Invention

The present invention provides: a process for producing soft, flexible and metalized polymeric article; the article thus obtained; footwear and/or components comprising soft, flexible and metalized polymer; and a process for the industrial production of footwear. The processes of the invention include the use of vacuum techniques for the deposition of metal and/or metal particles on an adhesive layer. The soft flexible and metalized polymer of the invention provides adequate characteristics for the manufacturing of footwear and footwear accessories.

Among the main technical advantages of the products and processes of the present invention, it can be mentioned that these metalized polymer products can be bent, twisted and deformed without losing the metalized look, i.e. maintaining the reflectivity of the metal layer.

### Process for Producing Polymeric Article

The process for producing soft, flexible and metalized polymeric article of the invention comprises the following steps:
a) applying an adhesive on a soft and flexible polymeric substrate;
b) applying metal or metal particles on said adhesive with a vacuum system; and
c) applying a protective varnish layer on the metallic film.

In a preferred embodiment, the soft and flexible polymeric substrate used is molded by rotomolding, transfer molding and resinated/spilled in plastisol resins, preferably they are injection molded. Blow molding processes could also be used.

The polymeric substrates used in the present invention are selected from: ethylene-vinyl acetate (EVA) copolymer; thermoplastic polyurethanes (TPU); poly(butylene-adipate-co-terephthalate) PBAT, thermoset polyurethanes (PU); acrylic polymers and their copolymers; thermoplastic rubbers (TR); polyvinyl chloride (PVC) and its copolymers; nitrile rubber (NBR); natural rubber (NR), ethylene-propylene-dimer (EPDM) copolymer; SBR rubber; SBS rubber and other elastomers, including mixtures thereof in any proportions, as well as the use of monomeric and polymeric plasticizers.

The hardness of the polymeric substrate should vary between 10 and 90 Shore A, preferably between 25 and 80 Shore A; and the elasticity zone between 10 and 1200%, preferably between 100 and 600%.

Once the soft and flexible polymeric substrate has been selected, the application of adhesive takes place in order to allow the anchoring of the metallic layer. The application of adhesive is made by spraying, dipping, hotmelt-type application and mechanical application by brush or roll of the same on the polymeric substrate.

Epoxy resin-based adhesives, acrylic resins, polyurethane resins, polychloroprene resins, ethylene-vinyl acetate (EVA) copolymer resins, polyvinyl alcohol (PVA) resins, polyvinyl chloride (PVC) resins, thermoplastic starch (TPS) resins; and starch, are used, including copolymers thereof and all mixtures in any proportions, with or without crosslinking, water base or solvent, mono- or bi- or poly-component. Additionally, hotmelt films are also optionally used. In a preferred embodiment, a solvent-based polyurethane system is used.

The evaporation and deposition of metal, as well as the adhesion of metallic film to the adhesive on the substrate, in a continuous or non-continuous process, is performed by the use of any technique that provides a vacuum system. In preferred embodiments, the techniques used are: Sputtering, thermal evaporation, ion beam, ion plating and chemical vapor deposition, preferably magnetron sputtering.

The metal particles used in the process and product of the invention are selected from the group including: nickel, chromium and nickel-chrome alloys, iron and iron-chromium-nickel alloys, such as stainless steel, aluminum, antimony, tin, indium, magnesium, silver, platinum, rhodium, palladium and tantalum and/or alloys thereof. In a preferred embodiment, chrome is used. Such particles provide characteristics of high reflectivity and high brightness of the metal.

In a preferred embodiment, the application of a protective layer of varnish on the metallic film is made. The preferably used varnishes are based on epoxy resins, acrylic resins, polyurethane resins, polychloroprene resins, ethylene-vinyl acetate (EVA) copolymer resins, polyvinyl alcohol (PVA) resins, polyvinyl chloride (PVC) resins, thermoplastic starch (TPS) resins and starch. Including copolymers thereof and all mixtures in any proportions, with or without crosslinking, water base or solvent, mono or bi-component, being hotmelt or non-hotmelt films. In a preferred embodiment, a solvent-based monocomponent polyurethane system is used.

### Soft Flexible and Metalized Polymeric Article

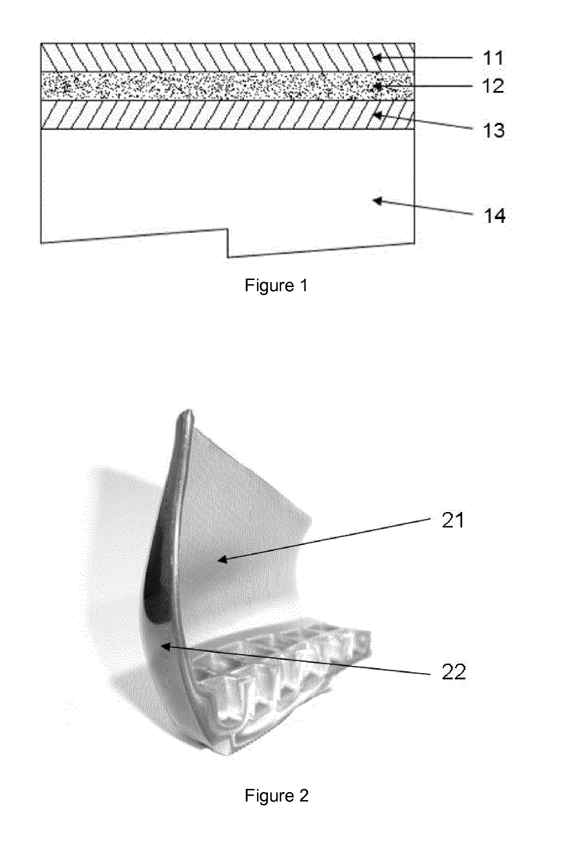

The present invention also provides a metalized soft and flexible polymeric article, diagrammed in figure 1. Said polymer is obtained by the above described process, comprising a substrate 14, an intermediate adhesive 13 and a metallic film 12 adhered to the adhesive 13, and optionally a protective varnish layer 11 on the metallic film 12.

### Process for Producing Footwear and/or Component Comprising Soft, Flexible and Metalized Polymer

The process for producing footwear and/or components of the invention comprises the following steps:
a) forming a footwear and/or soft and flexible polymer component;
b) applying an adhesive on at least one polymeric region of said footwear and/or component;
c) applying metal or metal particles on said adhesive with a vacuum system; and
d) applying a protective varnish layer on the metalized film.

The process of the present invention can be used in different processes of production of footwear and polymer components. In a preferred embodiment, the process comprises injection, in which the polymeric substrate is injected and forms the footwear/component. In this process, the already injected footwear and/or component receive a layer of adhesive and subsequently the assembly is subjected to vacuum for application of metal or metal particles. In this preferred embodiment, this is done via magnetron sputtering.

In a further embodiment of the process for producing shoes of the invention, the step of forming is conducted by rotomolding, transfer molding and resinated/spilled in plastisol resins.

In an alternative embodiment of the invention, the footwear/components to which the metals or metal particles are incorporated comprise a polymeric region at least partially devoid of metals or metal particles or have elements that provide visual contrast. In this way, at least part of polymeric structure of the footwear/component provides the visualization of the metals or metal particles and at least one of the external surfaces of the footwear/component.

In another alternative embodiment of the invention, the footwear/components to which the metals or metal particles are incorporated comprise polymeric mass fully or not fully devoid of pigments, the metals or metal particles embedded in the footwear providing a unique visual effect.

The characteristics of the process of the invention provide several advantages in the industrial production of footwear/components, including: better versatility in production on a large scale, since with the same transparent or single colored polymeric mass, footwear/components can be produced in various forms of metallization in one or more than one of their external surfaces.

The examples shown herein are only intended to exemplify one of the countless ways to carry out the invention, but without limiting the scope thereof.

Those skilled in the art will appreciate the knowledge presented herein and be able to reproduce the invention in the modalities presented and in other variants, covered in the scope of the appended claims

## Claims

1. Process for producing soft and flexible metalized polymeric article, **characterized in that** by comprising the following steps:
a) applying an adhesive over a soft and flexible polymeric substract;
b) applying a metal or metallic particles over the referred adhesive, with a vacuum system; and
c) applying a protecting layer of varnish over the metallic pellicle.

2. Process according to claim 1 **characterized in that** the polymeric substract is chosen from: ethylene-vinyl acetate (EVA), thermoplastic polyurethanes (TPU), Poly (butylene adipate-co-terephthalate) PBAT, thermo fixed polyurethane (PU), acrylic polymers and its copolymers, thermoplastic rubbers (TR), vinyl polychloride including its copolymers, nitrile rubber (NBR), natural rubber (NR), ethylene-propylene-dimer (EPDM) copolymer, SBR rubber, SBS rubber and other elastomers including a mixture of them in any proportion, as well as the use of polymeric and monomeric plastifiers.

3. Process according to claims 1 or 2, **characterized in that** the hardness of polymeric substract varies between 10 and 90 Shore A, preferably the hardness of polymeric substract varies between 25 and 80 Shore A.

4. Process according to one of claims 1 to 3, **characterized in that** the elasticity zone is within the range 10 to 1200%, preferably the elasticity zone is within the range 100 to 600%.

5. Process according to claim 1 **characterized in that** the step of applying the adhesive to the polymeric substract is done by spraying.

6. Process according to claim 1 **characterized in that** the used adhesive comprises epoxy resins, acrylic resins, polyurethanes resins, polychloroprene resins, copolymer ethylene-vinyl acetate (EVA) resins, polyvinyl alcohol resins, vinyl polychloride (PVC) resins, thermoplastic starch (TPS) and starch, including its copolymers and all the mixtures in any proportion, with our without crosslinking, water base or solvent, mono or bi-component, and thermofusible films.

7. Process according to claim 1 **characterized in that** the step of applying the metallic particles over the substract comprises the use of techniques: sputtering, thermal evaporation, ion beam, ion plating, chemical vapor deposition or magnetron sputtering.

8. Process according to claims 1 or 7 **characterized in that** the metallic pellicle is continuous or non-continuous.

9. Process according to any one of claims 1 to 8 **characterized in that** the used metals are chosen from: nickel, chrome, nickel-chrome alloys, iron and iron-chrome-nickel alloys like stainless steel, aluminum, tin, indium, magnesium, silver, platinum, rhodium, palladium and tantalum and/or its alloys.

10. Process according to one of claims 1 to 9 **characterized in that** additionally comprising the application of a protective layer of varnish on the metal pellicle.

11. Process according to claim 10, **characterized by** the fact that the varnish used comprise epoxy resins, acrylic resins, polyurethane resins, polychloroprene resins, ethylene- vinyl acetate (EVA) copolymer resins, polyvinyl alcohol (PVA) resins, polychloride vinyl (PVC) resins, thermoplastic starch (TPS) and starch including all their copolymers and mixtures in any proportions, with or without crosslinking, water-base or solvent, mono or bi-component, and thermofusible films.

12. Metalized polymeric article **characterized in that** is soft and flexible and it comprises a substract (14), an intermediate adhesive (13); and a layer having metals adhered to the adhesive (13); and, optionally, a varnish protecting layer (11) over a metallic pellicle (12).

13. Process for industrial producing of footwear and/or components **characterized in that** it comprises the steps of:
a) conforming a footwear and/or a soft and flexible polymeric component;
b) applying an adhesive on at least one polymeric region of said footwear and/or component;
c) applying metal or metallic particles on said adhesive, with the vacuum system, and
d) applying a protective layer of varnish on the metal pellicle.

14. Process according to claim 13 wherein the polymeric substrate is formed by rotational molding, transfer molding and resin/poured into plastisol resins or the polymeric substrate is formed by injection.

15. Footwear and/or polymeric component **characterized in that** at least part of its external surface comprises a soft polymer, flexible and metallized.

16. Footwear and/or polymeric component according to claim 15 wherein it comprises a substrate (14), an intermediate adhesive (13); and a layer containing metals (12) adhered to the adhesive (13); and, optionally, a varnish protecting layer (11) over a metallic pellicle (12).

17. Footwear and/or polymeric components **characterized in that** it is obtained by a process comprising the steps of:
a) forming a footwear and/or a soft and flexible polymeric component;
b) applying an adhesive on at least one polymeric region of said footwear and/or component;
c) applying metal or metallic particles on said adhesive, with the vacuum system, and
d) applying a protective layer of varnish on the metal pellicle.
